# EUROPEAN PATENT APPLICATION

(11) **EP 3 306 663 A1**
(43) Date of publication of application: **11.04.2018**
(21) Application number: 16192299.2
(22) Date of filing: 05.10.2016
(51) Int. Cl.: H01L 23/62, H01L 23/051, H01L 25/07

(54) **SIC-ON-SI-BASED SEMICONDUCTOR MODULE WITH SHORT CIRCUIT FAILURE MODE**

(71) Applicant: ABB Schweiz AG, 5400 Baden (CH)
(72) Inventor: LIU, Chunlei, 5452 Oberrohrdorf (CH); RAHIMO, Munaf, 5619 Uezwil (CH); STEIMER, Peter, 5420 Ehrendingen (CH)
(74) Representative: ABB Patent Attorneys

(57) **Abstract**

A semiconductor module (10) comprises a semiconductor chip (12) comprising a Si base layer (14) and a SiC epitaxy layer (16) on the Si base layer (14), the SiC epitaxy layer (16) comprising a semiconductor element (17); an electrical conducting top layer (Mo) (24) for providing an electrical contact of the semiconductor module (10) on a side of the SiC epitaxy layer (16); an electrical conducting bottom layer (Mo) (22) for providing an electrical contact of the semiconductor module (10) on a side of the Si base layer (14); and a failure mode layer (26, 26a, 26b) in contact with a top and/or bottom surface (18, 20) of the semiconductor chip (12) and arranged between the top layer (24) and the bottom layer (22), the failure mode layer (26, 26a, 26b) comprising a metal material (Al, Cu, Ag, Au) (27) adapted for forming a conducting path with the Si base layer (14), for example for forming a eutectic alloy with the Si base layer (14), to short-circuit the semiconductor module (10). The failure mode layer (26, 26b) at the bottom surface (20) of the semiconductor chip (12) may be coated to a core (30) of the bottom layer (22).

## Description

### FIELD OF THE INVENTION

The invention relates to a semiconductor module.

### BACKGROUND OF THE INVENTION

In high voltage DC applications, a series connection of multiple semiconductor modules is usually required to fulfil the high voltage requirements. A semiconductor module that in the case of a failure becomes permanently conducting may have great advantages in such series connections.

In semiconductor modules with a Si based semiconductor element, a metal preform may be provided on the base of a Si chip which is adapted to form a low melting eutectic alloy with the Si material of the chip and which creates a low ohmic path to conduct the full current load through the failure point. For example, the eutectic reaction between Si (silicon) and Al (aluminium) at a relative low temperature (577°C) makes it possible to provide such an intrinsic failure compensation.

Due to their high blocking capabilities, semiconductor modules with SiC (silicon carbide) based semiconductor elements are more and more employed in high voltage applications. However, the melting point of SiC (∼2730°C) is much higher than that of Si (1414°C) and there seems to be no such low temperature eutectic reaction between SiC and common metals.

Without an intrinsic short-circuit failure mode capability, the complexity and the cost of systems may increase, and this may also hinder the application of advanced SiC semiconductor modules in high voltage and/or high power applications, such as HVDC, STATCOM, etc., where series connections are usually needed.

4H-SiC is the commonly used crystalline form of silicon carbide for semiconductor devices, but it is difficult to grow on a Si wafer substrate due to the mismatch of lattice parameters and difference of crystal structures.

For example, RU 2 524 509 C relates to a method of producing thin epitaxial layers of Beta-SiC on monocrystalline silicon.

EP 2 503 595 A1 relates to a power semiconductor module with a semiconductor chip based on Si, which is provided between two layers that are capable of forming an eutectic alloy with the Si material of the chip.

### DESCRIPTION OF THE INVENTION

It is an object of the invention to provide a power semiconductor module with a SiC semiconductor device that has short circuit failure mode.

This objective is achieved by the subject-matter of the independent claims. Further exemplary embodiments are evident from the dependent claims and the following description.

The invention relates to a semiconductor module. A semiconductor module may be any kind of arrangement of a semiconductor chip together with further members such as electrical conducting layers, electrical conducting elements and/or electrical isolating element in mechanical and/or electrical contact with the semiconductor chips.

The semiconductor module may be a power semiconductor module, i.e. the semiconductor chip may be adapted to process voltages of more than 1 kV and/or more than 1 A.

According to an embodiment of the invention, the semiconductor module comprises: a semiconductor chip comprising a Si base layer and a SiC epitaxy layer on the Si base layer, the SiC epitaxy layer comprising a power semiconductor element; an electrical conducting top layer for providing an electrical contact of the semiconductor module on a side of the SiC epitaxy layer; an electrical conducting bottom layer for providing an electrical contact of the semiconductor module on a side of the Si base layer; and a failure mode layer in contact with a surface of the semiconductor chip and arranged between the top layer and the bottom layer, the failure mode layer comprising a metal material adapted for forming an conducting path, such as by forming a conducting material, with the Si base layer.

A conducting low ohmic path may be a path that has as resistance lower than the blocking semiconductor chip, such as 100 times or 1000 times lower. For example, the metal material may be adapted for forming an eutectic alloy with the Si base layer.

In other words, the semiconductor module comprises a stack of a top layer, a semiconductor chip and a bottom layer, which also comprises a metal material adapted for forming a low ohmic path in the case of a failure of the semiconductor chip, when the semiconductor chip becomes hot.

On the one hand, the semiconductor module may be based on a SiC semiconductor element, which has high blocking capabilities, and thus may be used in high voltage applications. On the other hand, the semiconductor module may provide a short circuit failure mode based on an eutectic reaction of the metal material and Si, which may start at rather low temperatures, such as below 1000° C. Due to the eutectic reaction, a low ohmic path is formed between the two sides of the semiconductor chip and the semiconductor module is short-circuited.

Additionally, the semiconductor module may be more economical, since a SiC semiconductor element in a SiC epitaxy layer on a Si base layer may have lower production cost than a SiC semiconductor element based on a SiC wafer.

According to an embodiment of the invention, the failure mode layer is in contact with the SiC epitaxy layer. Since a SiC epitaxy layer may be very thin, the eutectic reaction may start at rather low temperatures (such as less than 1000 °C), even when the Si base layer is separated from the failure mode layer by the SiC epitaxy layer.

According to an embodiment of the invention, the failure mode layer is a metal layer bonded to the top layer. It has to be noted that the failure mode layer only may be pressed on the SiC epitaxy layer and need not be bonded to the SiC epitaxy layer. The top layer may be used for mechanically supporting the failure mode layer.

According to an embodiment of the invention, the Si base layer is bonded to the bottom layer. When the failure mode layer is provided on the top side of the semiconductor chip with the SiC epitaxy layer, the bottom side of the semiconductor chip may be bonded to the bottom layer mechanically supporting the semiconductor chip. The bottom layer may be made of Mo (molybdenum) having a similar coefficient of thermal expansion as the Si base layer.

According to an embodiment of the invention, the failure mode layer is in contact with the Si base layer. Alternatively, the failure mode layer may be provided on the bottom side of the semiconductor chip in direct contact with the Si base layer. In this case, the semiconductor chip may be bonded to the failure mode layer.

It has to be noted that the semiconductor module may comprise two failure mode layers, wherein a first one is in contact with the SiC epitaxy layer and a second one is in contact with the Si base layer. These failure mode layers may have the same features as described in the above and in the below with respect to the single failure mode layers on the respective side of the semiconductor chip.

According to an embodiment of the invention, the failure mode layer is a metal layer of the bottom layer, which metal layer is coated to a core of the bottom layer. The bottom layer may comprise a coating in the form of a metal layer, which may cover the bottom layer not only on a surface facing the semiconductor chip, but also on its lateral sides. The semiconductor chip may be coated to the metal layer.

According to an embodiment of the invention, the core is made of Al-graphite (aluminium graphite composite), AlSiC (aluminium silicon carbide composite) or AlSip (aluminum matrix composite reinforced with high amount of silicon particles). These materials have similar thermal expansion coefficients as the Si base layer and/or support the failure mode layer, onto which the Si base layer may be bonded, with respect to thermal expansion of the semiconductor chip.

According to an embodiment of the invention, the top layer is made of or comprises Mo. For example, the failure mode layer may be bonded to a top layer of Mo supporting the failure mode layer with respect to thermal expansion in relation to the semiconductor chip.

According to an embodiment of the invention, the bottom layer is made of or comprises Mo. The semiconductor chip may be bonded to a bottom layer of Mo, which has a similar thermal expansion coefficient as the Si base layer.

According to an embodiment of the invention, the failure mode layer comprises aluminium, copper, silver or gold as metal material. In particular, the combination of Al and Si starts to form an eutectic material at a rather low temperature, which may help to form the short-circuiting path through the semiconductor chip very fast after a failure.

According to an embodiment of the invention, the SiC epitaxy layer is made of 3C-SiC. 3C-SiC has a cubic crystal structure and can be more easily grown on a Si substrate as other types of SiC. Furthermore, it has been proved that a 3C-SiC epitaxy layer does not hinder an eutectic reaction of a metal material and Si material separated by the 3C-SiC epitaxy layer.

According to an embodiment of the invention, the SiC epitaxy layer has a thickness of less than 50 µm. Since the SiC epitaxy layer has been deposited on the Si base layer, it may be made rather thin, such as 10 to 40 µm. In particular, it may be thinner (for example more than 10 times) than the Si base layer. Furthermore, it may be thinner (for example more than 10 times) as the failure mode layer.

According to an embodiment of the invention, the Si base layer has a thickness of more than 80 µm, for example between 100 µm and 400 µm.

According to an embodiment of the invention, the failure mode layer has a thickness of more than 100 µm. The failure mode layer may have a thickness such that enough material for forming the eutectic material is present. In the case of a coating of the bottom layer, such a coating may be thicker than 100 µm. In the case of a metal layer as failure mode layer in contact with the top surface of the semiconductor chip, this metal layer even may have a thickness of 500 µm or more. In the latter case, the failure mode layer may be provided in the form of a metal block that optionally may be bonded to the top layer as described in the above and in the following.

According to an embodiment of the invention, the top layer and/or the bottom layer have a thickness of more than 1 mm. In particular, these layers may be thicker more than 10 times the SiC epitaxy layer. The top layer and/or the bottom layer may be provided in the form of a metal block that optionally may be bonded to another layer as described in the above and in the following.

According to an embodiment of the invention, the semiconductor module further comprises a metal pin in contact with the top layer and pressing the top layer, the failure mode layer, the semiconductor chip and the bottom layer together. For example, the metal pin may be made of copper or brass and may be pressed against the top layer with an elastic element.

The semiconductor module may be stacked together with a further equally designed semiconductor module, such that the pin is in electrical contact with the bottom layer of the next semiconductor module. In such a way, the semiconductor module as described in the above and below may be electrically connected in series. When one of the semiconductor modules has a fault, the respective failure mode layer forms an electrically conduction eutectic material, bridging the semiconductor chip. Thus, the series connection of the semiconductor module may stay in operation with one semiconductor module less.

According to an embodiment of the invention, the semiconductor element comprises at least one of: a diode, a thyristor, a transistor, an IGBT, a bi-mode IGBT (BIGT), an IGCT, a bi-mode IGCT (BGCT), a MOSFET, a JFET, a GTO, etc.. In general, the semiconductor element may be a semiconductor switch formed in the SiC epitaxy layer. The semiconductor element may comprise a first electrode (such as an anode, cathode, drain or source) provided on the top surface of the SiC epitaxy layer and a second electrode provided on the bottom surface of the SiC epitaxy layer. Since the SiC base layer may be doped to be electrically conducting, the second electrode may be in electrical contact with the bottom surface of the semiconductor chip.

These and other aspects of the invention will be apparent from and elucidated with reference to the embodiments described hereinafter.

### BRIEF DESCRIPTION OF THE DRAWINGS

The subject-matter of the invention will be explained in more detail in the following text with reference to exemplary embodiments which are illustrated in the attached drawings.
Fig. 1 schematically shows a cross-section through a semiconductor module according to an embodiment of the invention.
Fig. 2 schematically shows a cross-section through a semiconductor module according to a further embodiment of the invention.

The reference symbols used in the drawings, and their meanings, are listed in summary form in the list of reference symbols. In principle, identical parts are provided with the same reference symbols in the figures.

### DETAILED DESCRIPTION OF EXEMPLARY EMBODIMENTS

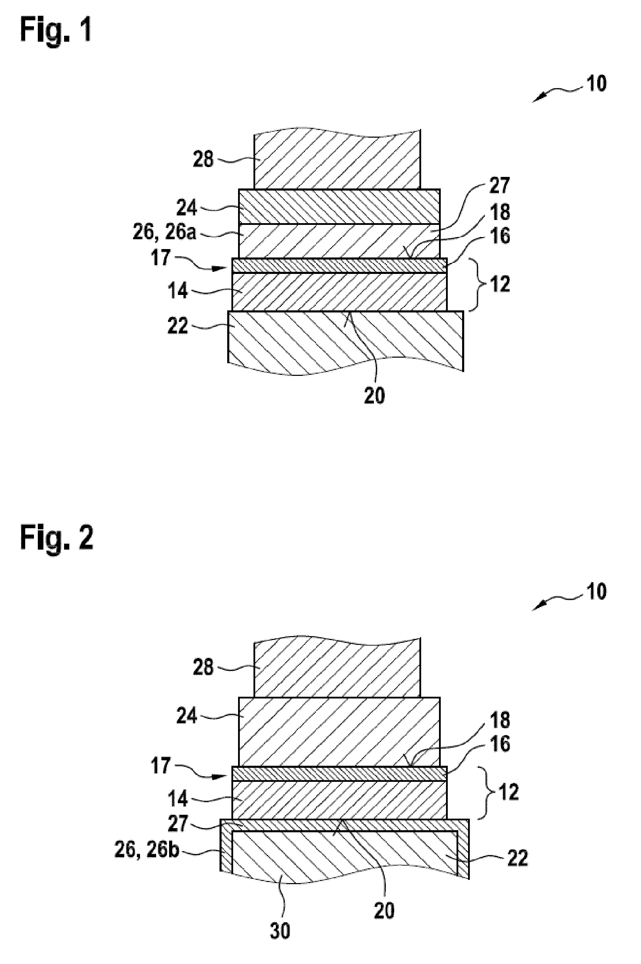

Fig. 1 shows a semiconductor module 10, which comprises a semiconductor chip 12 with a Si base layer 14 and a SiC epitaxy layer 16 on the Si base layer 14. In the SiC epitaxy layer 16, a semiconductor element 17 based on SiC is embedded. Examples for such semiconductor elements 17 are a diode, a thyristor, a transistor, an IGBT, an IGCT, etc.

For example, the semiconductor chip 12 may be made by first depositing the epitaxy layer 16 on the Si base layer 14 and then the semiconductor element 17 is produced by doping, etching, metalizing, etc. the SiC epitaxy layer 16.

The semiconductor chip 12 and also the other layers of the semiconductor module 10 may be shaped like a plate, for example, may have a cuboid or disc like form, wherein in one direction, the thickness is much thinner than in the other directions.

The SiC epitaxy layer 16 provides a top surface 18 with a first electrode of the semiconductor chip 12 and the Si base layer provides a bottom surface 20 of the semiconductor chip 12 with a second electrode of the semiconductor chip 12. The Si base layer 16 may be highly doped for having a low resistance and electrically interconnecting the SiC epitaxy layer 16 with the bottom surface 20. The top surface 18 of the semiconductor chip 12 and the bottom surface 20 may be substantially parallel with each other.

It has to be noted that the terms "top" and "bottom" have to be understood relative to the semiconductor chip 12 and that the semiconductor module 10 also may be mounted with the top surface facing to the ground, for example.

The SiC epitaxy layer 16 may be made of 3C-SiC and/or may have a thickness of less than 50 µm, for example 10 µm to 40 µm. On the other hand, the Si base layer 14 may have a thickness of more than 80 µm, for example 100 µm to 400 µm, and/or may be about 10 times or more thicker than the SiC epitaxy layer 16.

In Fig. 1, the Si base layer 14 is bonded with the bottom surface 20 to a bottom layer 22 of the semiconductor module 10. Bonding may relate to any process in which two members (here the Si base layer 14 and the bottom layer 22) are laminary connected with each other, for example by soldering, sintering, welding, etc.

The electrical conducting bottom layer 22 provides an electrical contact of the semiconductor module 10 on the side of the Si base layer 14, which electrical contact is electrically connected with the second electrode of the semiconductor chip.

Furthermore, the semiconductor module 10 comprises a top layer 24 and a failure mode layer 26, which failure mode layer 26 is accommodated between the top layer 24 and the semiconductor chip 12. For example, the failure mode layer 26 may be a metal plate 26a. The metal plate 26a may be bonded to the top layer and/or may directly contact the top surface 18 of the semiconductor chip 12.

The top layer 24 and the failure mode layer 26 are electrically conducting and thus the top layer 24 provides an electrical contact of the semiconductor module 10 on a side of the SiC epitaxy layer 16, which electrical contact is electrically connected with the first electrode of the semiconductor chip 12.

The failure mode layer 26 comprises a metal material 27 adapted for forming an eutectic alloy with the Si base layer 14. For example, the metal material may be Al, Cu, Ag or Au. Since the SiC epitaxy layer 16 is rather thin, in the case of a failure, the epitaxy layer 16 does not hinder the metal material 27 from the metal plate 26a to start an eutectic reaction with the Si material of the Si base layer 14.

It may be that the top layer 24 and the bottom layer 22 are made of a material or at least comprises a material with a coefficient of thermal expansion suited to the coefficient of thermal expansion of the semiconductor chip 12. For example, top layer 24 and/or the bottom layer 22 may be made of or may comprise Mo.

It has to be noted that the top layer 24 and the bottom layer may be much thicker than the SiC epitaxy layer 16, and, for example, may have a thickness of more than 1 mm. Also the metal plate 26a may be much thicker as the SiC epitaxy layer 16, and, for example, may have a thickness of more than 1 mm.

Fig. 1 also shows a metal pin 28 in contact with the top layer 24 and pressing the top layer 24, the failure mode layer 26, the semiconductor chip 12 and the bottom layer 22 together. It may be that the metal plate 26a is in free contact with the semiconductor chip 12 and/or that the top layer 24 is in free contact with the metal pin 28. The pressure of the pin 28 ensures that the semiconductor chip 12, the metal plate 26a, the top layer 24 and the pin 28 stay in mechanical and electrical contact.

The metal pin 28, which may be made of copper or brass, may be biased with an elastic element. For example, a further semiconductor module 10 designed like the one shown in Fig. 1 may be stacked on top of the metal pin 28, such that its bottom layer 22 is in electrical contact with the top layer.

Fig. 2 shows a further embodiment of a semiconductor module 10, which has a failure mode layer 26 in the form of a metal coating or metal skin 26b of the bottom layer 22, which metal coating 26b is in contact with the Si base layer 14. The metal coating 26b may have a thickness of more than 100 µm and/or may be coated around a core 30 of the bottom layer 22. Analogously to Fig. 1, the metal coating 26b may be made of Al, Cu, Ag or Au as metal material. The semiconductor chip 12 may be bonded with its bottom surface 20 to the metal coating 26b.

The core 30 may be made of a material with a coefficient of thermal expansion suited to the coefficient of thermal expansion of the semiconductor chip 12. For example, the core may be made of Al-graphite, AlSiC or AlSip.

On the top side, the semiconductor module of Fig. 2 may only have a top layer 24, for example made of Mo, which may be in free contact with the top surface 18 of the semiconductor chip 12. It also may be possible that on the top side a top layer 24 and a metal plate 26a as additional failure mode layer 26a is arranged, for example, as described with respect to Fig. 1.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art and practising the claimed invention, from a study of the drawings, the disclosure, and the appended claims. In the claims, the word "comprising" does not exclude other elements or steps, and the indefinite article "a" or "an" does not exclude a plurality. A single processor or controller or other unit may fulfil the functions of several items recited in the claims. The mere fact that certain measures are recited in mutually different dependent claims does not indicate that a combination of these measures cannot be used to advantage. Any reference signs in the claims should not be construed as limiting the scope.

### LIST OF REFERENCE SYMBOLS

- 10: semiconductor module
- 12: semiconductor chip
- 14: Si base layer
- 16: SiC epitaxy layer
- 17: power semiconductor element
- 18: top surface
- 20: bottom surface
- 22: bottom layer
- 24: top layer
- 26: failure mode layer
- 27: metal material
- 26a: metal plate
- 28: pin
- 30: core
- 26b: metal coating or metal skin

## Claims

1. A semiconductor module (10), comprising:
a semiconductor chip (12) comprising a Si base layer (14) and a SiC epitaxy layer (16) on the Si base layer (14), the SiC epitaxy layer (16) comprising a semiconductor element (17);
an electrical conducting top layer (24) for providing an electrical contact of the semiconductor module (10) on a side of the SiC epitaxy layer (16);
an electrical conducting bottom layer (22) for providing an electrical contact of the semiconductor module (10) on a side of the Si base layer (14);
a failure mode layer (26) in contact with a surface (18, 20) of the semiconductor chip (12) and arranged between the top layer (24) and the bottom layer (22), the failure mode layer (26) comprising a metal material (27) adapted for forming a conducting path with the Si base layer (14).

2. The semiconductor module (10) of claim 1,
wherein the failure mode layer (26a) is in contact with the SiC epitaxy layer (16).

3. The semiconductor module (10) of claim 1 or 2,
wherein the failure mode layer (26a) is a metal layer bonded to the top layer (24).

4. The semiconductor module (10) of one of the preceding claims,
wherein the Si base layer (14) is bonded to the bottom layer (22).

5. The semiconductor module (10) of one of the preceding claims,
wherein the failure mode layer (26b) is in contact with the Si base layer (14).

6. The semiconductor module (10) of one of the preceding claims,
wherein the failure mode layer (26b) is coated to a core (30) of the bottom layer (22).

7. The semiconductor module (10) of claim 6,
wherein the core (30) is made of Al-graphite, AlSiC or AlSip.

8. The semiconductor module (10) of one of the preceding claims,
wherein the top layer (24) is made of or comprises Mo; and/or
wherein the bottom layer (22) is made of or comprises Mo.

9. The semiconductor module (10) of one of the preceding claims,
wherein the failure mode layer (26) comprises Al, Cu, Ag or Au as metal material.

10. The semiconductor module (10) of one of the preceding claims,
wherein the SiC epitaxy layer (16) is made of 3C-SiC.

11. The semiconductor module (10) of one of the preceding claims,
wherein the SiC epitaxy layer (16) has a thickness of less than 50 µm; and/or wherein the Si base layer (14) has a thickness of more than 80 µm.

12. The semiconductor module (10) of one of the preceding claims,
wherein the failure mode layer (26) has a thickness of more than 100 µm.

13. The semiconductor module (10) of one of the preceding claims,
wherein the top layer (24) has a thickness of more than 1 mm; and/or
wherein the bottom layer (22) has a thickness of more than 1 mm.

14. The semiconductor module (10) of one of the preceding claims, further comprising:
a metal pin (28) in contact with the top layer (24) and pressing the top layer (24), the failure mode layer (26), the semiconductor chip (12) and the bottom layer (22) together.

15. The semiconductor module (10) of one of the preceding claims,
wherein the semiconductor element (17) comprises at least one of: a diode, a thyristor, a transistor, an IGBT, a bi-mode IGBT, an IGCT, a bi-mode IGCT , a MOSFET, a JFET, a GTO.
